Europäisches Patentamt

**European Patent Office**

Office européen des brevets

(11) Veröffentlichungsnummer : **0 008 668**
**B1**

(12) **EUROPÄISCHE PATENTSCHRIFT**

(45) Veröffentlichungstag der Patentschrift :
21.10.81

(51) Int. Cl.³ : **G 05 F 1/56, H 03 K 17/00**

(21) Anmeldenummer : **79102701.4**

(22) Anmeldetag : **30.07.79**

(54) **Konstantstrom-Schalter und Verwendung des Schalters zur Aussteuerung von Infrarot-Dioden.**

(30) Priorität : **01.09.78 DE 2838171**

(43) Veröffentlichungstag der Anmeldung :
**19.03.80 (Patentblatt 80/06)**

(45) Bekanntmachung des Hinweises auf die Patenterteilung : **21.10.81 Patentblatt 81/42**

(84) Benannte Vertragsstaaten :
**FR GB IT SE**

(56) Entgegenhaltungen :

**GB - A - 1 481 496**
**GB - A - 1 490 146**
**US - A - 3 678 291**
**US - A - 3 903 454**

(73) Patentinhaber : **Licentia Patent-Verwaltungs-GmbH**
**Theodor-Stern-Kai 1**
**D-6000 Frankfurt/Main 70 (DE)**

(72) Erfinder : **Moser, Helmut**
**Breslauerstrasse 53**
**D-7100 Heilbronn (DE)**
Erfinder : **Nutz, Karl-Diether**
**Blumenstrasse 33**
**D-7101 Oedheim (DE)**

(74) Vertreter : **Langer, Karl-Heinz (DE)**
**Hans-Sachs-Strasse 22**
**D-7100 Heilbronn (DE)**

Imprimerie Jouve, 17, rue du Louvre, 75001 Paris, France

Konstantstrom-Schalter und Verwendung des Schalters zur Austeuerung von Infrarot-Dioden

Die Erfindung betrifft einen Konstantstrom-Schalter zur Einstellung eines weitgehend konstanten schaltbaren Laststroms bei schwankender Versorgungsspannung mit einer Schaltung aus mehreren, je einen Transistor enthaltenden Stromzweigen.

Aus der US-A-3903454 ist eine Konstantstromquelle zur Einstellung des Laststroms einer Lampe bekannt. Diese Zweipol-Stromquelle besteht aus mehreren, je einen Transistor enthaltenden Stromzweigen, die jedoch zugleich Widerstände enthalten. Diese Widerstände verhindern, daß die Versorgungsspannung unter einen bestimmten Wert absinken kann.

Beispielsweise zur Aussteuerung von Hochleistungs-Infrarot-Dioden wird ein konstanter, relativ hoher Strom benötigt. Dabei wird verlangt, daß auch bei schwankender bzw. abnehmender Speisespannung in einem möglichst großen Spannungsbereich eine konstante Sendeleistung der Infrarot-Dioden, die vielfach für Datenübertragungsstrecken eingesetzt werden, gewährleistet ist.

Der Erfindung liegt die Aufgabe zugrunde, einen Konstantstrom-Schalter anzugeben, der in integrierter Halbleitertechnik mit möglichst geringem Bauelementeaufwand ausgeführt werden kann und der insbesonders eine relativ starke Abnahme der Versorgungsspannung zuläßt. Diese Aufgabe wird bei einem Konstantstrom-Schalter der eingangs genannten Art dadurch gelöst, daß in den vom Laststrom durchflossenem Stromzweig ein erster Bipolar-Transistor $(T_2)$ geschaltet ist, daß parallel zur Basis-Emitter-Strecke dieses Transistors $(T_2)$ ein Spannungsteiler $(R_1, R_2)$ zur Messung der Steuerspannung am ersten Transistor $(T_2)$ geschaltet ist, daß an die Verbindung zwischen den beiden Widerständen des Spannunsteilers die Basiselektrode des zweiten Transistors $(T_3)$ angeschlossen ist, daß die Emitterelektroden der beiden Transistoren auf gleichem Potential liegen und daß die Kollektorelektrode des zweiten Transistors $(T_3)$ mit dem Steuereingang der Schaltung und mit der Basiselektrode des ersten Transistors $(T_2)$ verbunden ist.

Die Transistoren sind bipolare Transistoren innerhalb einer integrierten Halbleiterschaltung, in der sich Abweichungen der Basis-Emitter-Spannungen der verschiedenen Transistoren ausgleichen und die Transistoren thermisch miteinander gekoppelt sind.

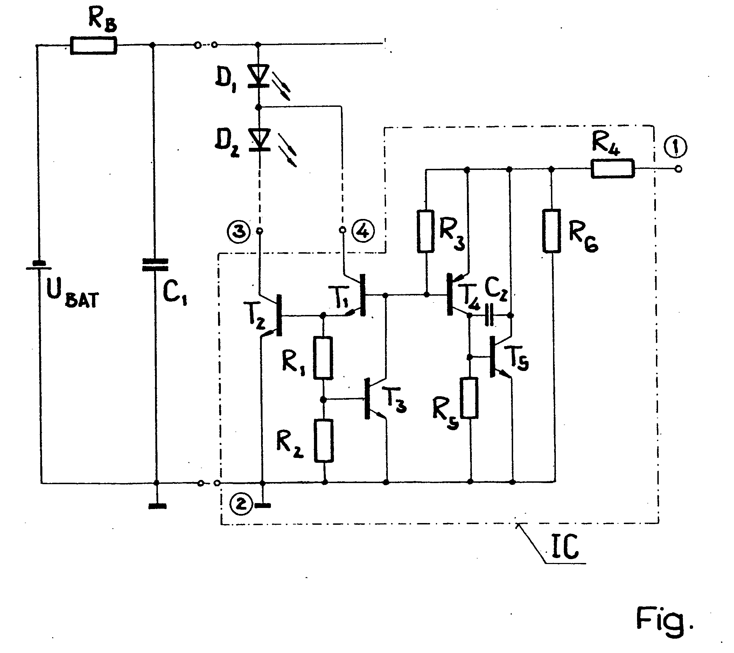

Die Erfindung und ihre weitere vorteilhafte Ausgestaltung soll noch anhand eines in der Figur dargestellten Ausführungsbeispieles näher erläutert werden. In der Figur ist der integrierte Halbleiterschaltkreis von einer Strichpunktierten Linie umrandet. Die Anschlußpins der integrierten Schaltung sind mit den Ziffern 1 bis 4 versehen.

Der Transistor $T_2$ dient zur Übernahme des Laststroms, der bei entsprechendem Aufbau dieses Transistors bis zu 10 A betragen kann. Parallel zur Basis-Emittter-Strecke des Transistors $T_2$ ist der Spannungsteiler aus den Widerständen $R_1$ und $R_2$ geschaltet. Die Verbindung zwischen diesen beiden Widerständen führt zur Basiselektrode des Transistors $T_3$, dessen Emitter auf gleichem Potential wie der Emitter des Transistors $T_2$ lieft. Zwischen den Kollektor des Transistors $T_3$ und die Basis des Transistors $T_2$ ist noch zusätzlich ein weiterer Transistor $T_1$ geschaltet, der mit seiner Emitterelektrode mit dem Basisanschluß des Transistors $T_2$ verbunden ist. Die Kollektorelektrode des Transistors $T_3$ führt zur Basiselektrode des Transistors $T_1$, während die Kollektorelektrode des Transistors $T_1$ mit Pin 4 verbunden ist. Die Kollektorelektrode des Transistors $T_2$ führt zu Pin 3.

Der Steueranschluß (Pin 1) ist über eine Konstantstrom-Schaltung mit der Basiselektrode des Transistors $T_1$ bzw. mit der Kollektorelektrode des Transistors $T_3$ verbunden. Diese Konstantstromquelle besteht aus den komplementären Transistoren $T_4$, un $T_5$, wobei die Emitterelektrode von $T_4$ und die Kollektorelektrode von $T_5$ über den Eingangswiderstand $R_4$ an den Steuereingang angeschlossen sind. Die Basiselektrode des Transistors $T_4$ ist mit der Basis elektrode des Transistors $T_1$ gekoppelt. Parallel zur Basis-Emitter-Strecke des Transistors $T_4$ liegt der Vorstromeinstellwiderstand $R_3$. Der Kollektor von $T_4$ ist mit der Basiselektrode von $T_5$ und über den Kollektorwiderstand $R_5$ mit dem Bezugspotential verbunden. Auf dem Bezugspotential liegt auch die Emitterelektrode des Transistors $T_5$.

Mit der beanspruchten Schaltung wird beispielsweise der Strom durch die hintereinander geschalteten, extern zuschaltbaren Infrarot-Dioden $D_1$ und $D_2$ gesteuert. Diese Dioden dienen beispielsweise zur Übertragung von Signalen bei Fernsteuerschaltungen. Als Spannungsquelle dient ein extern zuschaltbarer Kondensator $C_1$, der von einer Batterie $(U_{Batt})$ über den Batterie-Vorwiderstand $R_B$ aufgeladen wird und der über die Diodenstrecke und den Transistor $T_2$ entladen werden kann.

Es besteht die Möglichkeit, die Pins 3 und 4 zusammenzuschalten und mit der Reihenschaltung der Dioden $D_1$ und $D_2$ zu verbinden. Diese Schaltungsweise hat jedoch den Nachteil, daß die Spannungsquelle mindestens die Flußspannung der beiden Dioden, die Sättigungsspannung des Transistors $T_1$ und die Basis-Emitter-Spannung des Transistors $T_2$ liefern muß. Bei Unterschreitung dieser Spannung werden die Dioden $D_1$ und $D_2$ nicht mehr ausreichend mit Strom versorgt. Wird dagegen Pin 4 an die Verbindung zwischen den beiden Dioden $D_1$ und $D_2$ angeschlossen, während Pin 3 an die Reihenschaltung der beiden Dioden angeschlossen wird, darf die Versorgungsgleichspannung auf einen Wert absinken, der um die Sättigungsspannung des Transistors $T_2$ über der doppelten

Flußspannung der Dioden $D_1$ und $D_2$ liegt. Um beide Schaltungsarten zu ermöglichen, werden die Anschlüsse an die Kollektoren der Transistoren $T_1$ und $T_2$ getrennt aus der integrierten Schaltung herausgeführt.

Die Schaltung gemäß der Figur funktioniert wie folgt: Zur Durchsteuerung der Dioden $D_1$ und $D_2$ treten am Steuereingang (Pin 1) Steuerimpulse auf. Sobald am Basisanschluß des Transistors $T_1$ die Summe der Basis-Emitter-Spannungen der Transistoren $T_1$ und $T_2$ anliegt, wird der Transistor $T_2$ durchgesteuert, und ein hoher Strom fließt über die Kollektor-Emitter-Strecke des Transistors $T_2$ ab. Mit steigendem Strom durch den Transistor $T_2$ steigt auch die Basis-Emitter-Spannung $U_{BET2}$. Diese Spannung teilt sich entsprechend dem Teilerverhältnis auf die Widerstände $R_1$ und $R_2$ auf. Bei Überschreiten eines definierten Wertes reicht der Spannungsabfall am Widerstand $R_2$ aus, um den Transistor $T_3$ durchzusteuern, der nun dem Transistor $T_2$ Basisstrom entzieht, so daß die Aussteuerung des Transistors $T_2$ auf diese Weise begrenzt wird.

Das Prinzip der Schaltung beruht somit auf den unterschiedlichen Basis-Emitter-Spannungen der Transistoren $T_2$ und $T_3$, die durch unterschiedlich große Arbeitsströme hervorgerufen werden. Der Spannungsteiler ist beispielsweise so ausgelegt, daß bei $U_{BET2} = 1,0 V$ (entsprechend $I_{E2} = 2 A$) am Widerstand $R_2$ die zur Durchsteuerung des Transistors $T_3$ ausreichende Basis-Emitter-Spannung $U_{BET3} = 720 mV$ (entsprechend $I_{E3} = 1 mA$) abfällt.

Die Erfindung hat den Vorteil, daß die Emitterstrecke des Transistors $T_2$ widerstandslos sein kann, so daß bei der minimal zulässigen Versorgungsgleichspannung ein Spannungsabfall an dem sonst üblichen Meßwiderstand in der Emitterstrecke entfällt. Die an der integrierten Schaltung abfallende Restspannung ist somit äußerst gering und beträgt je nach Schaltungsart an Pin 3 und Pin 4 entweder $U_{CE2sat}$ bzw. $U_{BET2} + U_{CE1sat}$. Durch die Stromsteuerung am Transistor $T_2$ wird eine Sättigung dieses Leistungstransistors vermieden, so daß geringe Schaltzeiten verwirklicht werden können. Die Schaltung ist außerdem weitgehend temperaturunabhängig.

Die vorgeschaltete Konstantstromquelle sorgt dafür, daß bei ansteigender Steuerspannung am Eingang Pin 1 die Basis-Emitterspannung des Transistors $T_3$ konstant bleibt. Der diese Basis-Emitter-Spannung am Transistor $T_3$ bestimmende Nennstrom ergibt sich aux $I_{Nenn} = U_{BET4}/R_3$. Bei stark ansteigender Eingangssteuerspannung entlastet wiederum der Transistor $T_5$ den Transistor $T_4$, so daß sich auch die Basis-Emitter-Spannung am Transistor $T_4$ nicht wesentlich ändern kann. Der zwischen die Kollektorelektrode von $T_4$ und die Kollektorelektrode von $T_5$ geschaltete Kondensator $C_2$ dient der Verhinderung von Schwingungen.

Die in der Schaltung vorgesehenen Widerstände werden beispielsweise wie folgt dimensioniert:

$R_1 = 2.450 \ \Omega$
$R_2 = 4.850 \ \Omega$
$R_3 = 560 \ \Omega$
$R_4 = 2.000 \ \Omega$
$R_5 = 6.200 \ \Omega$

Der Widerstand $R_6$, der parallel zur Kollektor-Emitter-Strecke des Transistors $T_5$ liegt, hat einen Wert von 100 kΩ. Bei Verwendung einer Batterie mit einer Nennspannung von 9 V darf diese Spannung auf einen untersten Wert von ca. 6,2 V absinken, wenn die Durchlaßspannung der Infrarot-Dioden $D_1$ und $D_2$ 2,7 V und die Sättigungsspannung des Transistors $T_2$ 800 mV beträgt. Der Transistor $T_2$ muß so ausgelegt sein, daß er einen Strom von mehreren Ampere übernehmen kann. Die Transistoren $T_1$, $T_2$, $T_3$ und $T_5$ sind vorzugsweise NPN-Transistoren, während es sich bei dem Transistor $T_4$ um einen PNP-Transistor handelt.

**Ansprüche**

1. Konstantstromschalter zur Einstellung eines weitgehend konstanten schaltbaren Laststroms bei schwankender Versorgungsspannung, mit einer Schaltung aus mehreren, je einen Transistor enthaltenden Stromzweigen, dadurch gekennzeichnet, daß in den vom Laststrom durchflossenen Stromzweig ein erster Bipolar-Transistor ($T_2$) geschaltet ist, daß parallel zur Basis-Emitter-Strecke dieses Transistors ($T_2$) ein Spannungsteiler ($R_1$, $R_2$) zur Messung der Steuerspannung am ersten Transistor ($T_2$) geschaltet ist, daß an die Verbindung zwischen den beiden Widerständen des Spannungsteilers die Basiselektrode des zweiten Transistors ($T_3$) angeschlossen ist, daß die Emitterelektroden der beiden Transistoren auf gleichem Potential liegen und daß die Kollektorelektrode des zweiten Transistors ($T_3$) mit dem Steuereingang der Schaltung und mit der Basiselektrode des ersten Transistors ($T_2$) verbunden ist.

2. Konstantstromschalter nach Anspruch 1, dadurch gekennzeichnet, daß zwischen die Kollektorelektrode des zweiten Transistors ($T_3$) und die Basiselektrode des ersten Transistors ein dritter Transistor ($T_1$) geschaltet ist, indem die Kollektorelektrode des zweiten Transistors ($T_3$) mit der Basiselektrode des dritten Transistors ($T_1$) verbunden ist, dessen Emitterelektrode an den Spannungsteiler ($R_1$, $R_2$) und damit auch an die Basiselektrode des ersten Transistors ($T_2$) angeschlossen ist.

3. Konstantstromschalter nach Anspruch 1 oder 2, dadurch gekennzeichnet, daß die Transistoren innerhalb einer integrierten Halbleiterschaltung angeordnet sind, daß die Kollektorelektroden des ersten und des dritten Transistors ($T_2$, $T_1$) getrennt aus der integrierten Halbleiterschaltung herausgeführt sind, so daß sie gegebenenfalls an verschiedene Stellen des Laststromkreises anschließbar sind.

4. Konstantstromschalter nach einem der vorangehenden Ansprüche, dadurch gekennzeichnet, daß zwischen den Steuereingang der Schaltung und den zweiten bzw. den dritten Transistor ($T_3$, $T_1$) eine Konstantstromquelle geschaltet ist.

5. Konstantstromschalter nach einem der vorangehenden Ansprüche, gekennzeichnet durch seine Verwendung zur gleichmäßigen Aussteuerung von Hochleistungs-Infrarot-Dioden.

## Claims

1. A constant current switch for controlling a largely constant switchable load current in the case of a fluctuating supply voltage having a circuit comprising a plurality of current branches each branch containing a transistor, characterised in that a first bipolar transistor ($T_2$) is connected to the branch conducting load current ; that a voltage divider ($R_1$, $R_2$) for measuring the control voltage at the first transistor ($T_2$) is connected in parallel with the base-emitter path of said transistor ($T_2$) ; that the base electrode of the second transistor ($T_3$) is connected to the connection between the two resistors of the voltage divider ; that the emitter electrodes of the two transistors are at equal potential and that the collector electrode of the second transistor ($T_3$) is connected to the control imput of the circuit and to the base electrode of the first transistor ($T_2$).

2. A constant current switch according to claim 1 characterised in that a third transistor ($T_1$) is connected between the collector electrode of the second transistor ($T_3$) and the base electrode of the first transistor, while the collector electrode of the second transistor ($T_3$) is connected to the base electrode of the third transistor ($T_1$), the emitter electrode of which is connected to the voltage divider ($R_1$, $R_2$) and thereby to the base electrode of the first transistor ($T_2$).

3. A constant current switch according to claim 1 or 2 characterised in that the transistors are arranged within an integrated semiconductor circuit ; that the collector electrodes of the first and third transistors ($T_2$, $T_1$) have separate outputs from the integrated semiconductor circuit, so that, if desired they can be connected to different points in the load current circuit.

4. A constant current switch according to any one of the preceding claims, characterised in that a constant current source is connected between the control input of the circuit and the second and/or third transistor ($T_3$, $T_1$).

5. A constant current switch according to any one of the preceding claims characterised by its use to modulate high output infra-red diodes uniformly.

## Revendications

1. Interrupteur à courant constant pour le réglage d'un courant de charge pratiquement constant et commutable dans le cas d'une tension d'alimentation fluctuante, comprenant un circuit constitué par plusieurs voies contenant chacune un transistor, et caractérisé en ce qu'un premier transistor bipolaire ($T_2$) est inséré dans la voie parcourue par le courant de charge ; un diviseur de tension ($R_1$, $R_2$) est branché en parallèle avec le circuit base-émetteur de ce transistor ($T_2$) pour mesure de la tension de commande du premier transistor ($T_2$) ; l'électrode de base du second transistor ($T_3$) est reliée au point de connexion des deux résistances du diviseur de tension ; les électrodes d'émetteur des deux transistors sont reliées au même potentiel ; et l'électrode de collecteur du second transistor ($T_3$) est reliée à l'entrée de commande du circuit et à l'électrode de base du premier transistor ($T_2$).

2. Interrupteur à courant constant selon la revendication 1, caractérisé en ce qu'un troisième transistor ($T_1$) est connecté entre l'électrode de collecteur du second transistor ($T_3$) et l'électrode de base du premier transistor, l'électrode de collecteur du second transistor ($T_3$) étant reliée à l'électrode de base du troisième transistor ($T_1$), dont l'électrode d'émetteur est reliée au diviseur de tension ($R_1$, $R_2$) et par suite aussi à l'électrode de base du premier transistor ($T_2$).

3. Interrupteur à courant constant selon une des revendications 1 et 2, caractérisé en ce que les transistors sont disposés dans un circuit semiconducteur intégré ; et les électrodes de collecteur du premier et du troisième transistor ($T_2$, $T_1$) sont sorties séparément dudit circuit intégré, de façon à permettre le cas échéant de les relier à des points différents du circuit de charge.

4. Interrupteur à courant constant selon une quelconque des revendications 1 à 3, caractérisé par une source de courant constant, branchée entre l'entrée de commande du circuit d'une part et le second et le troisième transistor ($T_3$, $T_1$) d'autre part.

5. Interrupteur à courant constant selon une quelconque des revendications 1 à 4, caractérisé par son utilisation pour la commande régulière de diodes à infrarouge de haute puissance.

Fig.